# EUROPEAN PATENT APPLICATION

(11) **EP 2 211 390 A1**
(43) Date of publication of application: **28.07.2010**
(21) Application number: 08848896.0
(22) Date of filing: 13.11.2008
(51) Int. Cl.: H01L 31/042, B32B 27/36

(54) **REAR SURFACE PROTECTION SHEET FOR SOLAR CELL MODULE AND SOLAR CELL MODULE PROTECTED BY SUCH PROTECTION SHEET**

(30) Priority: 16.11.2007 JP 2007297852
(71) Applicant: Okura Industrial CO., LTD., 1515 Nakatsu-cho Marugame-shi Kagawa 763-0054 (JP)
(72) Inventor: NOGUCHI, Katsuhiro, Marugame-shi Kagawa 763-0054 (JP); IMAI, Naoya, Marugame-shi Kagawa 763-0054 (JP)
(74) Representative: Luderschmidt, Schüler & Partner
(86) International application number: PCT/JP2008/070661
(87) International publication number: WO 2009/063932

(57) **Abstract**

A back protective sheet for a solar cell module, including a three-layered composite film (3a) that has a pair of polybutylene terephthalate outer layers (1 a, 1 a) and a polycarbonate core layer (2a) that is interposed between the outer layers, and a moisture barrier layer (4) that is laminated on the composite film. A solar cell module that has photovoltaic elements that are protected by the back protective sheet. The three-layered composite film may be obtained by coextrusion.

## Description

### TECHNICAL FIELD

The present invention relates to a back protective sheet for a solar cell module and to a solar cell module having such a back protective sheet.

### BACKGROUND ART

Combustion of fossil fuel generates carbon dioxide which causes global warming. From the standpoint of reduction of carbon dioxide emission, therefore, solar cells are in the limelight as a clean energy source and are currently used for wide applications including private power generation and large scale power generation.

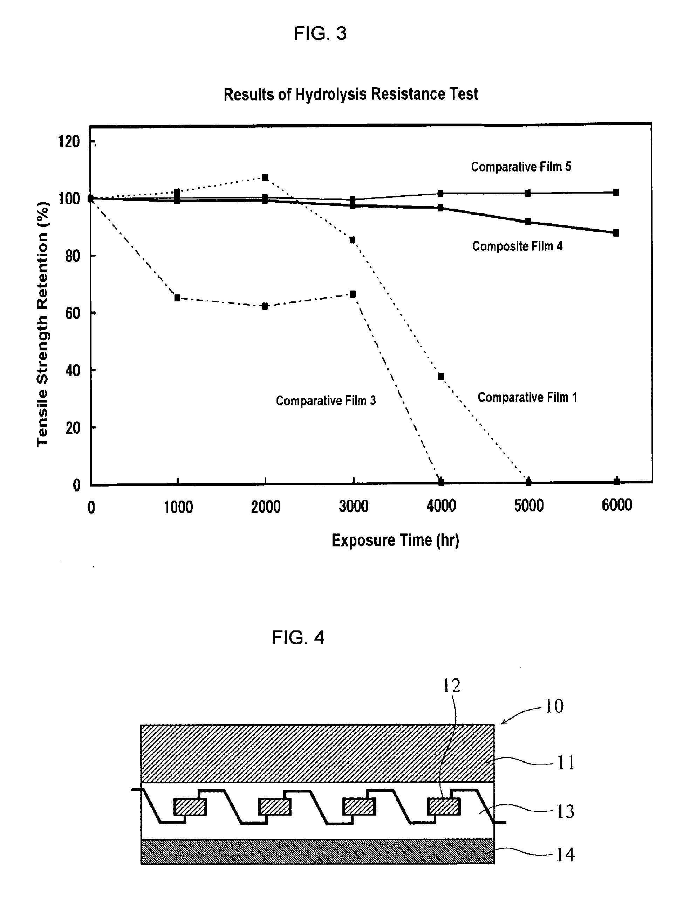

FIG. 4 is a schematic illustration of an ordinary solar cell module structure. The solar cell module 10 which constitutes a solar cell system has a front protective sheet 11, photovoltaic elements (including wires and electrodes) 12, a sealing material 13 for sealing the photovoltaic elements 12, and a back protective sheet 14 for covering and protecting the sealing material 13 and the photovoltaic elements 12. Such a solar cell module may be prepared by, for example, successively superimposing an ethylene-vinyl acetate copolymer resin (EVA) film as a sealing material, photovoltaic elements, an EVA film and a moisture barrier back protective sheet on a front protective sheet (such as glass) in this order. While being deaerated under reduced pressure, the assembly is then heated and pressed to fuse the EVA films so that the photovoltaic elements are sealed by the sealing material with the latter being covered and protected by the back protective sheet to impart durability and weather resistance to the solar cells and the solar cell module (see Japanese Examined Utility Model Publication No. H02-44995Y and Japanese Unexamined Patent Publication No. H11-186575A).

The back protective sheet is used for protecting the photovoltaic elements and sealing material. Namely, the back protective sheet performs important functions to prevent the photovoltaic elements from deteriorating by protecting the photovoltaic elements against external mechanical impact and pressure and by preventing moisture from penetrating from the outside to the photovoltaic elements. Such a back protective sheet is generally constituted of a moisture barrier film, such as a vapor deposited film, of aluminum oxide, silicon oxide or the like, formed on a substrate film, or of a combination of a moisture barrier layer such as a metal foil with a synthetic resin film having high strength, heat resistance and weather resistance.

Various proposals have been hitherto made on synthetic resin covering films for use in back protective sheets. For example, Japanese Examined Utility Model Publication No. H02-44995Y proposes a back protective sheet including a moisture barrier metal foil sandwiched between high strength, heat resistant, weather resistant resin films, such as of polycarbonate, polymethyl methacrylate, polyacrylate or polyethylene terephthalate, and a glassy material vapor deposition layer formed on the resin film. Japanese Unexamined Patent Publication No. H11-186575A proposes a back protective sheet including an aluminum foil sandwiched between polyvinyl fluoride films.

Japanese Unexamined Patent Publication No. 2002-100788A proposes a back protective sheet formed of a laminate of a hydrolysis-resistant polyethylene terephthalate film containing a specific amount of an oligomer, a metal oxide-vapor deposited film, and a white-colored film.

Further, Japanese Unexamined Patent Publication No. 2006-324556A proposes a back protective sheet having a polycarbonate film and laminated thereon a gas barrier, transparent, vapor deposited film of an inorganic oxide. Japanese Unexamined Patent Publication No. 2007-129204A proposes a back protective sheet having a polybutylene terephthalate film containing titanium oxide or a laminate of such a polybutylene terephthalate film.
The synthetic resin films used in these back protective sheets may be roughly classified into polyethylene terephthalate-based films, polybutylene terephthalate-based films, polycarbonate-based films and polyvinyl fluoride-based films.

However, these resin films have both good points and bad points and are not fully satisfactory with respect to strength, durability and weather resistance which are required for use in a back protective sheet. For example, polyethylene terephthalate-based (hereinafter referred to as PET) films have a problem because the thermal shrinkage thereof is high. Thus, during the preparation of a solar cell module, wires thereof are apt to be bent due to thermal shrinkage of the films. Additionally, PET films are easily hydrolyzed and, therefore, have a problem that they have poor weather resistance. Polybutylene terephthalate-based (hereinafter referred to as PBT) films have good durability and weather resistance. However, from the standpoint of future use, there is a demand for a resin film which exhibits improved durability and weather resistance for a longer period of time.

On the other hand, polycarbonate-based (hereinafter referred to as PC) films have very excellent hydrolysis resistance but have poor resistance to organic solvents. Thus, for example, PC films have a problem with respect to suitability for dry lamination with other films. Also, fluorine resin-based films have very excellent durability but are expensive and disadvantageous from the standpoint of economy. Further, fluorine resin-based films have a problem that a toxic fluorine-based gas is generated upon incineration.

As a moisture barrier layer used in back protective sheets, there have been hitherto used a metal foil such as an aluminum foil. Recently, however, from the standpoint of light weight and electrical insulation, a moisture barrier film composed of a synthetic resin substrate film and a moisture barrier layer of an inorganic oxide such as aluminum oxide or silicon oxide formed by vapor deposition or sputtering on the substrate film is widely used. In particular, a PET film on which a layer of silicon oxide is formed by vapor deposition is generally used for reasons of its easy commercial availability and relative inexpensiveness.

### DISCLOSURE OF THE INVENTION

### Problems to be Solved by the Invention:

In view of the above-described problems of the conventional technology, the present invention is aimed at the provision of a back protective sheet for a solar cell module which excels in weather resistance and durability and is inexpensive, and a solar cell module that has such a back protective sheet.

### Means for Solving the Problems:

In accordance with a first aspect of the present invention, there is provided a back protective sheet for a solar cell module, which comprises a three-layered composite film that has a pair of polybutylene terephthalate outer layers and a polycarbonate core layer which is interposed between the outer layers, and a moisture barrier layer that is laminated on the composite film.

In a second aspect of the present invention, the above-described three-layered composite film is produced by coextrusion. In a third aspect of the present invention, each of the above-described outer layers has a thickness of 5 to 30% of a total thickness of the above-described composite film and the above-described core layer has a thickness of 40 to 90% of the total thickness. In a fourth aspect of the present invention, the above-described moisture barrier layer is a metal foil, a film of an inorganic oxide, a moisture barrier resin film, or an inorganic oxide thin layer that is deposited on a substrate film. According to a fifth aspect of the present invention, there is provided a back protective sheet for a solar cell module, which comprises the above-described three-layered composite film that is laminated on both sides of the moisture barrier layer. According to a sixth aspect of the present invention, there is provided a solar cell module which comprises photovoltaic elements that are protected by any one of the back protective sheets of the first to fifth aspects. Effect of the Invention:

The composite film which is used in the present invention can achieve such very improved weather resistance, hydrolysis resistance and organic solvent resistance that are not expected at all from a single layer film of PBT or PC. The back protective sheet of the present invention in which such a composite film is used together with a moisture barrier layer is low in thermal shrinkage and is excellent in hydrolysis resistance, in weather resistance, in organic solvent resistance and in moisture barrier property.
Therefore, the back protective sheet of the present invention enables to provide a solar cell module which can maintain excellent weather resistance and durability for a long period of time without causing deterioration of its photovoltaic elements.
Further, because the composite film is low in thermal shrinkage, the back protective sheet that uses the composite film is also low in thermal shrinkage and, therefore, permits the preparation of a solar cell module without adversely affecting its sealing material, photovoltaic elements and wires.

### BRIEF DESCRIPTION OF THE DRAWINGS

FIG. 1 is a cross-sectional view schematically illustrating one embodiment of a back protective sheet according to the present invention.
FIG. 2 is a cross-sectional view schematically illustrating another embodiment of a back protective sheet according to the present invention.
FIG. 3 shows graphs showing changes in tensile strength retention (%) with exposure time when a composite film for use in the back protective sheet according to the present invention and comparative films were each exposed to an environment having a temperature of 85°C and a humidity of 85%.
FIG. 4 is a cross-sectional view schematically illustrating a structure of a solar cell module.

### BEST MODE FOR CARRYING OUT THE INVENTION

A back protective sheet of the present invention will be described in detail below with reference to the accompanying drawings.

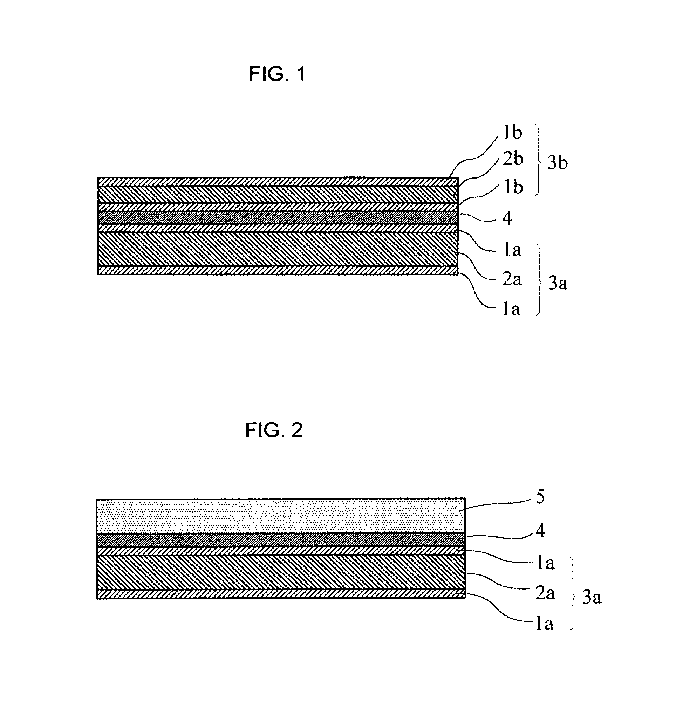

FIG. 1 is a cross-sectional view schematically illustrating one embodiment of the present invention. The illustrated back protective sheet is a laminate which comprises a composite film 3a that has a polycarbonate (PC) core layer 2a which is sandwiched between a pair of polybutylene terephthalate (PBT) outer layers 1a and 1a; a moisture barrier layer 4 that has a PET substrate film on which a moisture barrier thin layer of vapor deposited silicon oxide (not shown) is formed; and a composite film 3b that has a PC core layer 2b which is sandwiched between a pair of PBT outer layers 1b and 1b. The back protective sheet may be bonded to a back surface of a solar cell module, as shown in FIG. 4, with the composite film 3b thereof facing the photovoltaic element 12 side.

The PBT for use in producing the composite film of the back protective sheet according to the present invention is a polyester that contains butylene terephthalate as a main recurring unit. As a typical example of PBT, there may be mentioned a polyester that is obtained by polycondensation of 1,4-butanediol as a glycol component with terephthalic acid or its lower alcohol ester as a dicarboxylic acid component. As long as the objects and effects of the present invention are not adversely affected, PBT may contain other glycol components and/or other dicarboxylic acid components.
For example, not more than 20 mole % of the total glycol components and/or the total dicarboxylic acid components may be replaced by other glycol components and/or other dicarboxylic acid components. Thus, for example, such PBT may be a copolyester in which not more than 20 mole % of 1,4-butanediol as a glycol component is replaced by other glycol or glycols such as ethylene glycol, propylene glycol and triethylene glycol and/or in which not more than 20 mole % of terephthalic acid or its lower alcohol ester as a dicarboxylic acid component is replaced by other dicarboxylic acid or acids such as isophthalic acid and orthophthalic acid. The melting point of PBT for use in the present invention is generally 200 to 230°C, preferably 215 to 230°C. For reasons of suitable extrudability, it is preferred that PBT have an intrinsic viscosity of 0.6 to 1.5.
Additives such as a slipping agent, an anti-blocking agent, a stabilizer, an antistatic agent, an anti-fogging agent, an antioxidant, a UV absorbing agent, a filler, a plasticizer and a coloring agent may be added to PBT, as desired, to the extent that they do not degrade the properties of PBT.

The PC for use in producing the composite film of the back protective sheet is not specifically limited. Thus, PC that is conventionally used in applications in which hydrolysis resistance and weather resistance are required may be arbitrarily used. From the standpoint of hydrolysis resistance, weather resistance and heat resistance, PC that has a number average molecular weight (Mn) of 10,000 to 50,000 is preferably used. Also, aromatic PC of a bisphenol A-type is preferable. PC that is disclosed in, for example, aforementioned Japanese Unexamined Patent Publication No. 2006-324556A may be used.
Additives such as a slipping agent, an anti-blocking agent, a stabilizer, an antistatic agent, an anti-fogging agent, an antioxidant, a UV absorbing agent, a filler, a plasticizer and a coloring agent may be added to PC, as desired, to the extent that they do not degrade the properties of PC. It is particularly preferred that at least one weather resistance improving agent that is selected from UV absorbing agents and hindered amine-type stabilizers be added to aromatic PC in an amount of 0.001 to 5 parts by weight per 100 parts by weight of aromatic PC. Various types of modified PC may also be used for the purpose of the present invention.

The ratio (%) in thickness of (PBT outer layer):(PC core layer):(PBT outer layer) in the composite film of the present invention is preferably such that each of the outer PBT layers has a thickness of 5 to 30% of a total thickness of the composite film and the core PC layer has a thickness of 40 to 90% of the total thickness of the composite film. Namely, the ratio in thickness of (PBT outer layer):(PC core layer):(PBT outer layer) is preferably (30 to 5%):(40 to 90%):(30 to 5%), more preferably (27 to 8%):(46 to 84%):(27 to 8%). When the thickness of the PC layer of the composite film is less than 40% of the total thickness of the composite film, the hydrolysis resistance of the film is reduced so that the durability and weather resistance are occasionally deteriorated. On the other hand, when the thickness of the PC layer is more than 90% of the total thickness of the composite film, the organic solvent resistance is occasionally deteriorated.

A method for producing the composite film is not specifically limited. Any method that is generally customarily employed may be adopted. However, a coextrusion method that uses a multilayer die may be effectively used. It is particularly preferable to adopt a coextrusion method in which a T die casting machine that is equipped with, for example, a three-layer die is used.

As the moisture barrier layer of the back protective sheet according to the present invention, there may be used, for example, a metal foil such as an aluminum foil; a moisture barrier resin film such as a cyclic olefin-based resin film that has excellent moisture barrier property; a film of an inorganic oxide, such as aluminum oxide or silicon oxide, that has moisture barrier property; and an inorganic oxide thin layer, such as of aluminum oxide and silicon oxide, that has moisture barrier property and is deposited on a substrate film. From the standpoint of light weight and electrical insulation, an inorganic oxide thin layer that is deposited on a substrate film may be preferably used as the moisture barrier layer. Such an inorganic oxide thin layer may be formed on the substrate film by a customarily employed method such as vacuum deposition, sputtering, physical vapor deposition (PVD) or chemical vapor deposition (CVD). In this case, a PET film may be generally used as the substrate film. However, the substrate film is not limited thereto. It is of course possible to use a PBT film or the above-described composite film of the present invention as the substrate film for directly forming the moisture barrier layer thereon.
The thickness of the moisture barrier layer may be such as to provide desired moisture barrier property and varies with the material from which the moisture barrier layer is made. For example, the thickness of a thin film of an inorganic oxide is generally 5 to 300 nm. Thus, the lower limit of the thickness of the moisture barrier layer is about 5 nm. The thicknesses of a metal foil, a moisture barrier resin film and a substrate film for an inorganic oxide thin layer are generally 5 to 500 µm, preferably 8 to 300 µm. Thus, the upper limit of the thickness of the moisture barrier layer is about 500 µm.

The back protective sheet of the present invention will be concretely described below.
A back protective sheet that is shown in FIG. 2 has an intervening film 5 which is provided, if necessary, on that side of the back protective sheet which is to contact a sealing material. The intervening film 5 is required to have adhesiveness to the sealing material and to exhibit sufficient heat resistance at the time of the fabrication of the solar cell module. As the intervening film 5, there may be mentioned, for example, a PET film, a PBT film and the aforementioned composite film that is used in the present invention. For reasons of excellent adhesiveness and heat resistance, the composite film is particularly preferably used as the intervening film 5. When the intervening film 5 that is shown in FIG. 2 is the aforementioned composite film that is used in the present invention, then the resulting back protective sheet may be the same as that shown in FIG. 1. If necessary, a known resin film that has weather resistance may be provided on the opposite side of the back protective sheet from the side which is to contact the sealing material.

Examples of suitable structures of the back protective sheet include:
(A) [composite film 3a] / [moisture barrier layer 4 (substrate film/inorganic oxide thin layer)] / [composite film 3b] as shown in FIG. 1;
(B) [composite film 3a] / [moisture barrier layer 4 (metal foil, for example] / [intervening film 5] as shown in FIG. 2;
(C) [composite film] / [moisture barrier layer (inorganic oxide thin layer/substrate film, for example)];
(D) [composite film] / [moisture barrier layer (film of inorganic oxide, for example)] / [composite film];
(E) [composite film] / [moisture barrier layer (film of inorganic oxide, for example)] / [intervening film]; and
(F) [resin film having weather resistance] / [moisture barrier layer (substrate film/ inorganic oxide thin layer, for example)] / [composite film].
The films and layers in the above structural examples (A) to (F) are arranged in the stated order.
The thickness of the composite film that is used in the present invention is preferably 30 to 200 µm. A white pigment may be compounded into a film on the sealing material side or its opposite side to form a white-colored film, if desired.

As a lamination method for forming the back protective sheet, there may be used any method that is generally used for laminating resin films. A dry lamination method that uses an adhesive such as a polyurethane-based adhesive or an epoxy-based adhesive may be preferably used. It is of course possible to use various primers in order to improve the adhesion between the layers.

### EXAMPLES

The following preparation examples, examples and comparative examples will further illustrate the present invention.

The composite films and back protective sheets were evaluated for their performance by the methods that are shown below. The use of composite films which excel in thermal shrinkage, hydrolysis resistance and weather resistance can give back protective sheets that show satisfactory performance.

### Thermal shrinkage:

A specimen film that had a length and a width of 200x200 mm was heated in a hot wind drying oven at 150°C for 30 minutes to measure the heat shrinkage. Thus, the length and width were measured before and after the heating, from which shrinkage-values in both directions were calculated. The thermal shrinkage of the specimen film represents the greater of the two values. When the thermal shrinkage is high, there occurs a problem that a copper wire that connects between solar cells is damaged before the completion of hardening of EVA during a heat press step at 150°C in the manufacture of a solar cell module. A thermal shrinkage at 150°C of 1% or less, particularly 0.5% or less, is generally considered to be preferred.

### Hydrolysis resistance:

A specimen film was exposed to a high temperature and high humidity environment (temperature: 85°C, humidity: 85%), which is much severer than the natural conditions in which solar cell apparatuses are generally used, to measure changes in tensile strength retention (%) (degree of retention of the tensile strength thereof) with exposure time (hr) and to evaluate the hydrolysis resistance. The tensile strength was determined in accordance with JIS K-7127. A film that has a tensile strength retention (%) of at least 65% after exposure for 3,000 hours under the above-described conditions is acceptable for practical use. A film that has a tensile strength retention (%) of an appreciable degree (at least 50%) after exposure for 6,000 hours may be said to be very excellent in hydrolysis resistance.

### Weather resistance:

A specimen film was measured for its tensile strength retention (%) and color change after exposure for 500 hours using a sunshine weather meter and for evaluating the weather resistance. A degree of color change is expressed in terms of color difference (ΔE^{*}ab) in L^{*}a^{*}b^{*} color system (color indication method defined in JIS Z-8729) between before and after the weather resistance test.

### Preparation Examples:

Polybutylene terephthalate (PBT, melting point: 225°C, intrinsic viscosity: 1.14) and polycarbonate (number average molecular weight: 25,000) were coextruded through a two-resin three-layer T-die to obtain various composite films as shown in Table 1. For the purpose of comparison, PET, PBT and PC were each extruded to obtain films as shown in Table 1. In the case of Composite Film 6, a titanium dioxide white pigment was compounded into PC so that the core layer was a white-colored film. In the similar manner, Comparative Film 4 was formed into a white-colored film. The obtained films were each measured for their thermal shrinkage. The results are also shown in Table 1.

**Table 1**

| | Structure | Thickness (µm) | Thickness ratio (%) | Thermal shrinkage (%) |
|---|---|---|---|---|
| Composite Film 1 | PBT/PC/PBT | 100 | 25/50/25 | 0.22 |
| Composite Film 2 | PBT/PC/PBT | 100 | 20/60/20 | 0.18 |
| Composite Film 3 | PBT/PC/PBT | 100 | 10/60/30 | 0.12 |
| Composite Film 4 | PBT/PC/PBT | 100 | 10/80/10 | 0.12 |
| Composite Film 5 | PBT/PC/PBT | 138 | 10/80/10 | 0.22 |
| Composite Film 6 | PBT/PC (white) /PBT | 100 | 10/80/10 | 0.25 |
| Comparative Film 1 | weather resistant PET | 50 | - | 1.18 |
| Comparative Film 2 | PBT | 188 | - | 0.3 |
| Comparative Film 3 | PBT | 100 | - | 0.36 |
| Comparative Film 4 | PBT (white) | 50 | - | 0.5 |
| Comparative Film 5 | PC | 100 | - | 0.26 |

From the thermal shrinkage values shown in Table 1, it is appreciated that, the dimensional changes by heat of Composite Films 1 to 6 according to the present invention are one digit smaller than that of Comparative Film 1 and are smaller than those of Comparative Films 2, 3 and 4. Therefore, Composite Films 1 to 6 will not adversely affect sealing materials, photovoltaic elements and wires during the fabrication of solar cell modules. The PC film of Comparative Film 5 shows dimensional stability which is comparable to that of the composite films of the present invention. It was found, however, that the PC film was not practically usable because, when the PC film was brought into contact with an adhesive at the time of dry lamination, the surface thereof was dissolved in an organic solvent contained in the adhesive and was turned white.

Composite Film 4 which is a typical example of the composite film of the present invention was tested for its weather resistance and hydrolysis resistance. Also, Comparative Films 1, 3 and 5 for the comparison purposes were tested for their hydrolysis resistance, and Comparative Films 3 and 5 were tested for their weather resistance. The results of the weather resistance test are shown in Table 2, while the results of the hydrolysis resistance test are shown in FIG. 3.

**Table 2**

| | | |
|---|---|---|
| | Weather resistance | |
| | Color difference | Tensile strength retention (%) |
| Composite Film 4 | 4.0 | 80 |
| Comparative Film 3 | 6.0 | 57 |
| Comparative Film 5 | 11.0 | 70 |

From Table 2, it is appreciated that Composite Film 4 according to the present invention shows better weather resistance as compared with the conventional PBT film (Comparative Film 3) and the PC film (Comparative Film 5).
The results shown in FIG. 3 indicate that the weather resistant PET film (Comparative Film 1) and the PBT film (Comparative Film 3) show tensile strength retentions (%) after 3,000 hours exposure of 85% and 66%, respectively, which are generally acceptable values. However, their tensile strength retentions (%) after 6,000 hours exposure were each 0%. The PC film (Comparative Film 5), on the other hand, shows excellent hydrolysis resistance.
In contrast, Composite Film 4 according to the present invention shows tensile strength retention (%) of 87% even after 6,000 hours exposure and has very excellent hydrolysis resistance. Thus, it is understood that Composite Film 4, when used as a back protective sheet of solar cell modules, enables to improve the durability and weather resistance thereof.

### Example 1 and Comparative Example 1:

In Example 1, a back protective sheet that has a structure as shown in FIG. 1 was prepared by a dry lamination method that used a polyurethane-based adhesive agent. As the moisture barrier layer, a film (thermal shrinkage: 1.18%) that was composed of a PET film with a thickness of 12 µm and a silicon dioxide (SiO₂) layer that was formed on the PET film by vapor deposition was used. In Comparative Example 1, for the purpose of comparison, PBT films (Comparative Films 2 and 4) were substituted for the Composite Films 5 and 6 to obtain a back protective sheet. The thermal shrinkages of the thus obtained back protective sheets are also shown in Table 3.

**Table 3**

| | Structure | Thickness (µm) | Thermal shrinkage (%) |
|---|---|---|---|
| Example 1 | Composite Film 6 / Moisture-barrier layer / Composite Film 5 | 250 | 0.32 |
| Comparative Example 1 | Comparative Film 4 / Moisture-barrier layer / Comparative Film 2 | 250 | 1.29 |

As shown in Table 3, the back protective sheet of Example 1 according to the present invention has extremely low thermal shrinkage in spite of the fact that the moisture-protective layer used has a high thermal shrinkage of 1.18%.
In contrast, the back protective sheet of Comparative Example 1 in which the PBT films are used has a far greater thermal shrinkage than those of the PBT films by themselves and, therefore, is not satisfactory for use as a back protective sheet for solar cell modules.
Using the back protective sheet of Example 1 according to the present invention, a solar cell module that had a structure as shown in FIG. 4 was fabricated such that Composite Film 6 thereof faced the sealing material (photovoltaic element) side. The back protective sheet was found to show satisfactory performance with respect to both heat resistance during the fabrication and adhesion to the sealing material.

### INDUSTRIAL APPLICABILITY

The present invention provides a back protective sheet which has a low thermal shrinkage and which excels in hydrolysis resistance, in weather resistance and in barrier properties against water, gases and water vapor, and makes it possible to provide solar cell modules with excellent durability at a low cost without using expensive fluorocarbon-based films.
The invention may be embodied in other specific forms without departing from the spirit or essential characteristics thereof. The present embodiments are therefore to be considered in all respects as illustrative and not restrictive, the scope of the invention being indicated by the appended claims.

## Claims

1. A back protective sheet for a solar cell module, comprising
a three-layered composite film that has a pair of polybutylene terephthalate outer layers and a polycarbonate core layer which is interposed between the outer layers, and
a moisture barrier layer that is laminated on the composite film.

2. The back protective sheet according to claim 1, wherein the three-layered composite film is produced by coextrusion.

3. The back protective sheet according to claim 1 or 2, wherein each of the outer layers has a thickness of 5 to 30% of a total thickness of the composite film and the core layer has a thickness of 40 to 90% of the total thickness.

4. The back protective sheet according to any one of claims 1 to 3, wherein the moisture barrier layer is a metal foil, a film of an inorganic oxide, a moisture barrier resin film, or an inorganic oxide thin layer that is deposited on a substrate film.

5. The back protective sheet according to any one of claims 1 to 4, wherein the composite film is laminated on both sides of the moisture barrier layer.

6. A solar cell module comprising photovoltaic elements that are protected by a back protective sheet according to any one of claims 1 to 5.
